# DEMANDE DE BREVET EUROPEEN

(11) **EP 4 822 451 A1**
(43) Date de publication de la demande: **14.10.2026**
(21) Numéro de dépôt: 25169753.8
(22) Date de dépôt: 10.04.2025
(51) Int. Cl.: G04B 17/06, B81C 1/00, B81C 99/00, G04B 17/22, G04D 3/00

(54) **PROCÉDÉ DE FABRICATION DE COMPOSANTS HORLOGERS EN SILICIUM**

(71) Demandeur: Richemont International S.A., 1752 Villars-sur-Glâne (CH)
(72) Inventeur: CHABART, Mickaël, 2014 Fleurier (CH); DEMOLON, Pierre, 2023 Gorgier (CH); MONTINARO, Enrica, 3012 Bern (CH); OULEVEY, Zoé, 1188 St-George (CH)
(74) Mandataire: Novagraaf International SA

(57) **Abrégé**

Un procédé de fabrication de composants horlogers (90) en silicium comprend les étapes suivantes : se doter d'une plaquette multi-couches (10) comprenant une première couche de support (20) en silicium, une deuxième couche de support (12, 15), une couche de travail (30) en silicium, et une première couche enterrée (40) en oxyde de silicium ; former les composants horlogers (90) en gravant des motifs dans la couche de travail (30) afin d'obtenir une couche de travail structurée (30' ; structurer des parties exposées de la première couche d'oxyde enterrée (40) afin d'obtenir une première couche d'oxyde enterrée ajourée (40') ; structurer la première couche de support (20) afin d'obtenir une première couche de support structurée (20') ayant au moins une région (22, 24) où le matériau de la première couche de support (20) en dessous d'au moins un composant horloger (90) a été éliminé ; éliminer les parties de la première couche d'oxyde enterrée (40) restant entre l'au moins une région éliminée (22, 24) de la première couche de support structurée (20') et ledit au moins un composant horloger (90) agencé au-dessus de ladite région (22, 24). Après ces étapes, la première couche d'oxyde enterrée structurée (40") a des parties subsistantes (42, 44) liant toujours la couche de support structurée (20') à la couche de travail structurée (30'), et la première couche de support structurée (20') est toujours supportée par la deuxième couche de support (12, 15).

## Description

### Domaine technique

L'invention concerne un procédé de fabrication de composants horlogers en silicium sur une plaquette multicouche telle qu'une plaquette de type « silicon-on-insulator » (SOI). Un tel procédé de fabrication comprend généralement des étapes de microfabrication incluant la lithographie et la gravure des couches de la plaquette ainsi que des étapes de fabrication postérieures à la gravure incluant la libération des composants.

### Etat de la technique

La fabrication de composants horlogers en silicium tels que (de façon non limitative) des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage par gravure dans une plaquette en silicium. Les procédés de réalisation de ces composants horlogers utilisent généralement des plaquettes de silicium monocristallin, mais des plaquettes en silicium polycristallin ou amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde SiO₂ sur le composant. Quand les composants horlogers sont réalisés à partir d'une plaquette en silicium monocristallin, l'une quelconque des trois orientations cristallines <100>, <110> ou <111> peut être utilisée.

Les plaquettes de silicium sont proposées sous forme de galette simple, par exemple des wafers de type SSP (« Single Side polished » en anglais) ou de type DSP (« Dual Side Polished » en anglais). Le document EP3495894 décrit un procédé de fabrication de composants horlogers en silicium utilisant une telle plaquette comprenant une couche simple en silicium sans couche de support. Selon ce document, la plaquette simple a une épaisseur sensiblement égale à l'épaisseur maximale des composants horlogers à fabriquer, et pour former les composants horlogers, on effectue une étape de gravure dans toute l'épaisseur de la plaquette, la totalité du matériau du composant présent dans la plaquette étant ainsi utilisée pour former les composants horlogers, sans fonction de support dans la plaquette. Après leur formation, les composants horlogers ne sont supportés structurellement que par des ponts de liaison fins qui les maintiennent attachés aux parties subsistantes de la couche simple en silicium, et il est possible d'effectuer des étapes de fabrication subséquentes sur la quasi-totalité de la surface externe des composants sans qu'il soit nécessaire d'effectuer une étape de libération des composants auparavant. Cependant, dans le procédé de fabrication du document EP3495894, l'étape de gravure est délicate car elle a lieu dans une plaquette relativement mince, et donc fragile, sans aucun support.

Alternativement, les plaquettes SOI (« silicon-on-insulator » en anglais) sont souvent utilisées pour la fabrication de composants horlogers. Une plaquette SOI comprend une couche de travail en silicium (la couche « device » en anglais) dans laquelle les composants horlogers sont fabriqués, une couche de support en silicium qui sert de substrat ou de support lors de la fabrication des composants (la couche « handle » en anglais), et une couche d'oxyde enterrée en SiO₂ qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail d'une plaquette SOI, les composants sont normalement libérés de la couche de support et de la couche d'oxyde enterrée de la plaquette SOI afin de faciliter des étapes de fabrication subséquentes. De cette manière, après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur quasiment l'ensemble de la surface externe des composants de la plaquette. Les étapes subséquentes peuvent notamment comprendre des étapes d'oxydation et désoxydation pour le lissage des surfaces des composants. Les étapes subséquentes peuvent également comprendre des étapes d'oxydation et désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique. Après ces étapes subséquentes, les composants horlogers peuvent être détachés de la plaquette et montés dans par exemple le mouvement d'une pièce d'horlogerie.

La libération des composants horlogers sur une plaquette SOI peut être réalisée par différentes méthodes. Une approche de libération est décrite dans les documents de brevet JP2017219520 et WO2019180177. Selon cette approche, après la formation des composants par gravure, on fait croître une couche d'oxyde de silicium en surface du silicium. Cette couche d'oxyde sert de protection pour les composants formés. Par la suite, on réalise une photolithographie et une gravure pour exposer le silicium de la couche de support et graver la couche de support en l'attaquant par la face opposée aux composants, ce qui enlève la couche de support en dessous des composants. Pour terminer la libération selon cette alternative, on élimine la couche enterrée du wafer SOI en dessous des composants ainsi que la couche de protection sur les composants. Cette approche de libération est relativement longue et couteuse, car elle exige une structuration (voire des étapes de photolithographie et de gravure) au travers de la couche de support épaisse de la plaquette SOI.

Selon une autre approche décrite dans le document WO2019180596, après la formation des composants, la couche de travail (ou une partie de cette couche comprenant les composants) est séparée de la couche de support. Cette séparation peut être facilitée par la gravure d'une saignée entourant les composants ainsi que des ouvertures dans la couche de travail. Par la suite, la couche d'oxyde enterrée est gravée avec de la vapeur d'acide hydrofluorique (HF) qui passe au travers des ouvertures dans la couche de travail, et la partie de la couche de travail définie par la saignée est séparée de la couche de support de la plaquette SOI. Dans cette approche de libération, puisque la couche de travail est beaucoup plus fine et fragile que la couche de support, la réalisation d'étapes de fabrication subséquentes est plus délicate et risquée car elles sont effectuées sans le bénéfice de la couche de support, même pour le cas où elle est partiellement éliminée.

Il serait alors avantageux d'avoir un procédé de fabrication de composants horlogers en silicium comprenant des étapes de libération des composants qui sont moins longues, plus efficaces et qui permettent de garder le bénéfice d'un support structurel pour des étapes de fabrication subséquentes qui ont lieu sur les composants après leur libération.

### Bref résumé de l'invention

Un but de la présente invention est de proposer un procédé de fabrication d'une pluralité de composants horlogers sur une plaquette multi-couches telle qu'une plaquette double-SOI, qui permet d'éviter ou de pallier les inconvénients ci-dessus, ou en tout cas d'offrir un meilleur compromis entre ces inconvénients.

Ce but est au moins partiellement atteint en proposant un nouveau procédé de fabrication de composants horlogers en silicium selon lequel les composants sont libérés sans une gravure longue et couteuse d'une couche de support et selon lequel on peut garder le bénéfice d'un support structurel pour des étapes de fabrication subséquentes effectuées sur les composants après leur libération. En particulier, ce but est au moins partiellement atteint en utilisant une plaquette multi-couches, de préférence de type double SOI, avec une couche de travail et au moins deux couches de support incluant une couche de support principale et une première couche de support sacrificielle qui est structurée (éventuellement préalablement, avant l'assemblage de la plaquette, mais de préférence après la formation des composants horlogers) pour libérer les composants horlogers et une deuxième couche de support qui n'a pas besoin d'être gravée pour la libération et peut rester intacte.

Ainsi, selon un aspect, la présente invention concerne un procédé de fabrication, d'une pluralité de composants horlogers en silicium, dans une plaquette multi-couches, les composants horlogers présentant des flancs ayant des surfaces, le procédé comprenant les étapes suivantes (pouvant être mises en œuvre dans cet ordre ou selon une autre séquence) : (a) se doter de la plaquette multi-couches comprenant une première couche de support en silicium, une deuxième couche de support, une couche de travail en silicium, et une première couche enterrée en oxyde de silicium séparant la première couche de support de la couche de travail , la première couche de support étant supportée par la deuxième couche de support; (b) former les composants horlogers en gravant des motifs dans la couche de travail afin d'obtenir une couche de travail structurée , la couche de travail structurée comprenant des régions autour des motifs gravés dans lesquelles le matériau de la couche de travail a été éliminé pour exposer la première couche d'oxyde enterrée en-dessous ; (c) structurer des parties exposées de la première couche d'oxyde enterrée afin d'obtenir une première couche d'oxyde enterrée ajourée comprenant des régions éliminées de la première couche d'oxyde enterrée ; (d) structurer la première couche de support afin d'obtenir une première couche de support structurée ayant au moins une région où le matériau de la première couche de support en dessous d'au moins un composant horloger a été éliminé ; et (e) éliminer les parties de la première couche d'oxyde enterrée restant entre ladite au moins une région éliminée de la première couche de support structurée et ledit au moins un composant horloger agencé au-dessus de ladite région , afin d'obtenir (ou jusqu'à obtenir) une première couche d'oxyde enterrée structurée ayant des parties subsistantes liant toujours la couche de support structurée à la couche de travail structurée , la première couche de support structurée étant toujours supportée par la deuxième couche de support.

Selon un mode de réalisation, la deuxième couche de support n'est pas structurée et reste intacte. La deuxième couche de support peut être réutilisable dans une plaquette multi-couches du même type pour un autre lot de fabrication de composants horlogers. Elle peut être réalisée en au moins un des matériaux suivants : le silicium, l'oxyde de silicium, le carbure de silicium, l'oxyde de hafnium, l'alumine, le nitrure de silicium, le verre, et/ou un métal.

La plaquette multi-couches peut comprendre également une deuxième couche enterrée séparant la première couche de support de la deuxième couche de support. Dans ce cas, la deuxième couche de support peut être réalisée en silicium et la deuxième couche enterrée peut être réalisée en oxyde de silicium.

De préférence, la première couche de support a une épaisseur moins importante que l'épaisseur de la deuxième couche de support. La première couche de support (20) peut avoir une épaisseur inférieure ou égale à 50 µm et/ou une épaisseur d'au moins 3 µm.

Dans un mode de réalisation, la structuration de la première couche de support a lieu avant un assemblage de la plaquette multi-couches, afin que la couche de support structurée se trouve déjà dans la plaquette multi-couches avant la formation des composants horlogers à l'étape (b).

Dans un autre mode de réalisation, à l'étape (d) on effectue une gravure du silicium dans la première couche de support à travers la première couche d'oxyde enterrée ajourée afin d'obtenir la première couche de support structurée. Dans ce mode, le procédé peut comprendre une étape de former, avant l'étape (d), une couche de protection au moins sur les surfaces des flancs des composants horlogers gravés à l'étape (b). Par ailleurs selon ce mode de réalisation, soit la deuxième couche enterrée soit la deuxième couche de support peut avantageusement servir à arrêter la gravure de la première couche de support à l'étape (d). La gravure de la première couche de support à l'étape (d) peut comprendre une gravure isotrope utilisant un plasma à base d'hexafluorure de soufre (SF₆) ou une gravure isotrope en phase vapeur à base de difluorure de xénon (XeF₂).

D'autres caractéristiques avantageuses et privilégiées du procédé de fabrication sont précisées dans la description et les sous-revendications ci-dessous.

### Brève description des figures

Des exemples de mise en œuvre de l'invention sont indiqués dans la description illustrée par les figures annexées dans lesquelles :
- Les figures 1a-1m illustrent schématiquement une série d'étapes de fabrication d'un composant horloger en silicium dans une plaquette multi-couches selon un mode de réalisation ;
- Les figures 2, 2A et 2B sont des vues de dessus de la couche de travail d'une plaquette double-SOI et d'un composant horloger sur la plaquette après les étapes de la figure 1 selon un mode de réalisation ;
- La figure 3 est une vue en section selon la ligne III-III de la figure 2 ; et
- Les figures 4a-4q illustrent schématiquement une série d'étapes de fabrication d'un composant horloger en silicium dans une plaquette multi-couches selon un autre mode de réalisation.

### Exemples de mode de réalisation de l'invention

Dans tout ce qui suit, les orientations sont les orientations des figures. En particulier, les termes comme « supérieur », « inférieur », « gauche », « droit », « dessus », « dessous », « horizontal », « latéral », « vertical », « vers l'avant » et « vers l'arrière » s'entendent généralement par rapport au sens de représentation des figures. Les figures sont schématiques et peuvent présenter des proportions et/ou des aspects différents de la réalité même au sein d'une même figure, mais illustrent à tout le moins le déroulement et/ou les étapes des procédés décrits.

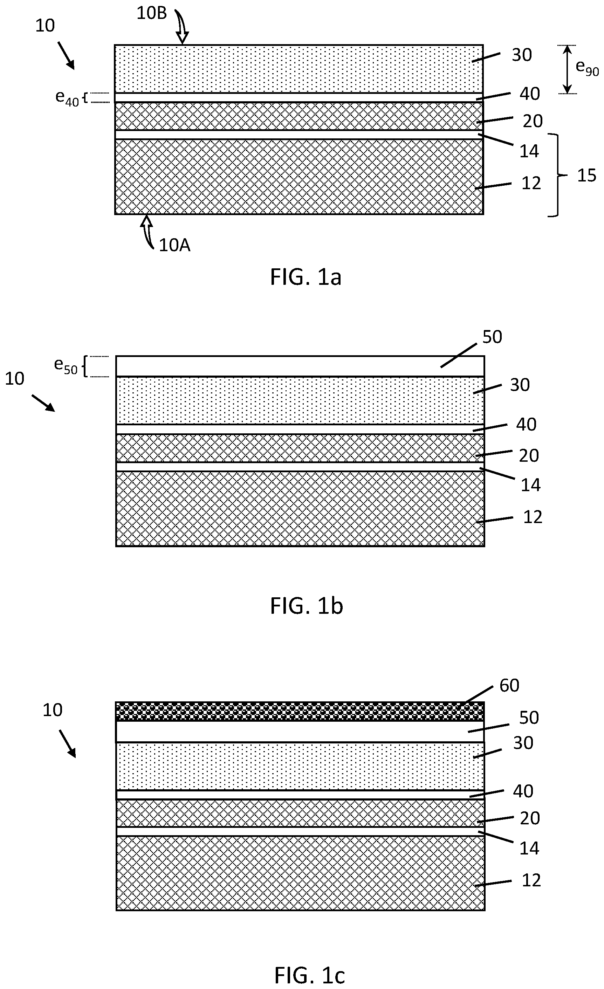

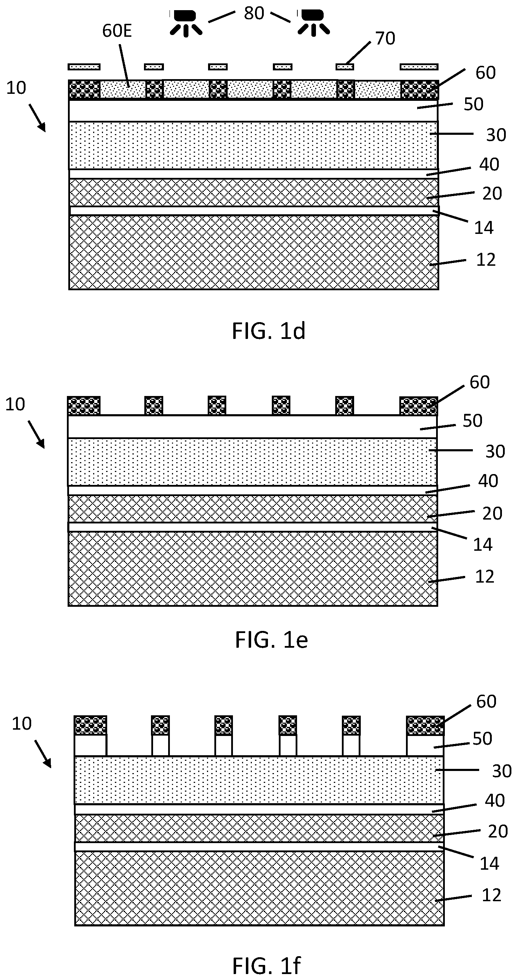

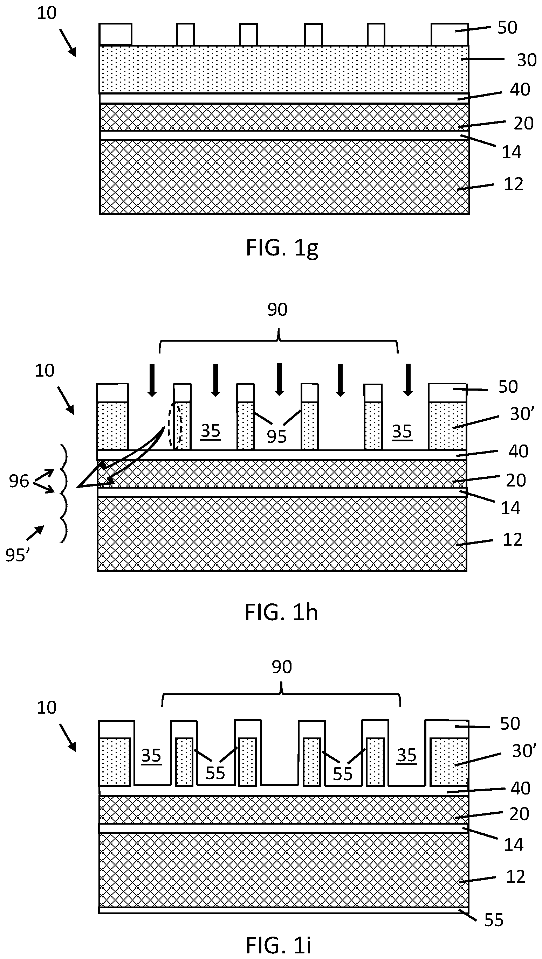

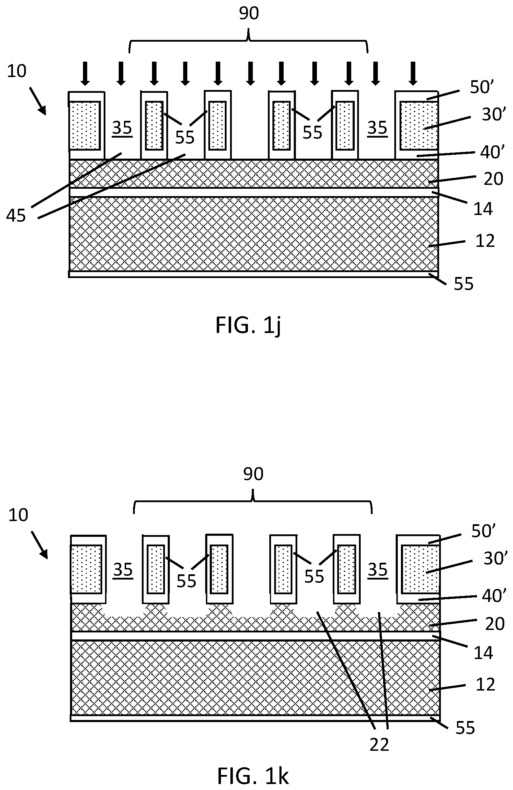

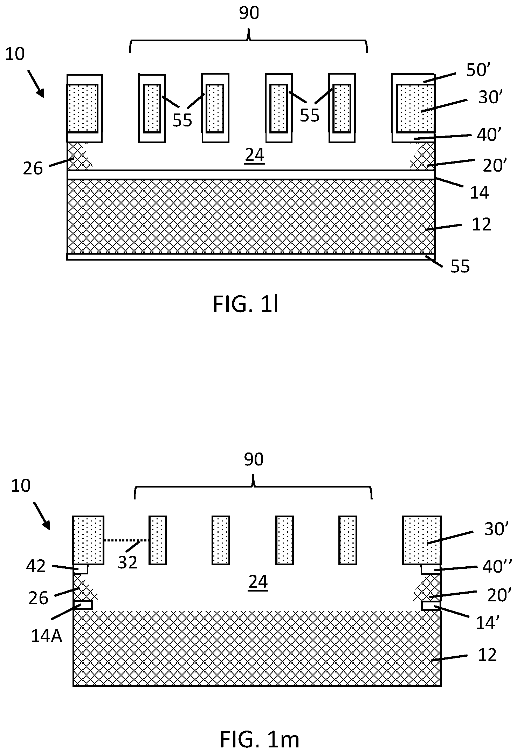

Les figures 1a-1m illustrent une série d'étapes de fabrication schématiques d'un composant horloger dans une plaquette multi-couches 10 selon un mode de réalisation de l'invention. Bien entendu, plusieurs composants horlogers peuvent être fabriqués dans la plaquette 10 en même temps, mais les vues de la figure 1 sont isolées sur un seul composant par simplicité.

Le procédé commence en se dotant d'une plaquette multi-couches qui est selon ce mode de réalisation illustré une plaquette de type « double-SOI » comprenant deux couches de support et une couche de travail, ces couches étant séparées les unes des autres par des couches d'oxyde enterrées. Plus particulièrement, la plaquette 10 comprend une couche de travail 30 en silicium, dans laquelle les composants horlogers seront formés, et une première couche de support 20 en silicium qui est séparée de la couche de travail 30 par une première couche d'oxyde enterrée 40 en oxyde de silicium (SiO₂). Dans ce mode de réalisation, la plaquette 10 comprend également une deuxième couche de support 12 qui est séparée de la première couche de support 20 par une deuxième couche enterrée 14. Selon cet exemple, la deuxième couche de support 12 est aussi en silicium, et la deuxième couche enterrée 14 est aussi en oxyde de silicium (SiO₂).

La couche de support 20 et surtout la couche de support 12 accordent un support structurel à la plaquette durant les étapes de fabrication, et en particulier la première couche de support 20 est supportée par la deuxième couche de support 12. Comme le sera décrit ci-dessous, la première couche de support 20 est une couche sacrificielle qui est de préférence structurée durant des étapes pour libérer les composants horlogers après leur formation. Cependant, selon une variante, la structuration de la première couche de support 20 a lieu avant un assemblage de la plaquette multi-couches 10, afin qu'une couche de support structurée 20' se trouve déjà dans la plaquette multi-couches 10 avant la formation des composants horlogers.

Cette première couche de support 20 est de préférence relativement mince par rapport à la deuxième couche de support 12 qui avantageusement peut être une couche permanente qui reste intacte et n'est pas gravée ou structurée durant le procédé de fabrication. Autrement dit, la première couche de support 20 a une épaisseur moins importante, et de préférence considérablement moins importante que l'épaisseur de la deuxième couche de support 12. Pour cette raison, le matériau de cette couche n'est pas critique, et elle peut par exemple être réalisée en un autre matériau que le silicium tel que l'oxyde de silicium (SiO₂), le carbure de silicium (SiC), l'oxyde de hafnium (HfO₂), l'alumine (Al₂O₃), le nitrure de silicium (Si₃N₄), le verre et/ou un métal tel qu'aluminium. A cet égard, la deuxième couche de support 12 peut également être réutilisable pour différents lots de fabrication, en collant ou liant (par exemple, par collage anodique ou par « wafer bonding » en anglais) une plaquette SOI plutôt « classique » comprenant les couches 20, 30 et 40 à la couche de support 12 (au début du procédé de fabrication et en séparant la couche de support 12 de ces couches à la fin du procédé afin qu'elle puisse être réutilisée.

La deuxième couche d'oxyde enterrée 14 est de préférence en oxyde de silicium (SiO₂), mais elle peut aussi être réalisée dans un autre matériau isolant capable d'arrêter la gravure de la première couche de support 20 durant la libération, tel qu'un autre oxyde comme l'Al₂O₃ ou le TiO₂. Selon le matériau de la deuxième couche de support 12, la deuxième couche enterrée 14 peut également être en un matériau métallique (tel que l'or) ou à base de carbone, par exemple en graphène. Une couche 14 en graphène facilite la réutilisation de la couche de support 12, et optionnellement la couche enterrée 14 elle-même, pour supporter des nouvelles couches 20, 30 et 40 afin de fabriquer un autre jeu de composants horlogers comme décrit dans la demande de brevet européen no. 24210124 déposée au nom de la titulaire de la présente demande.

Dans un mode de réalisation, la deuxième couche de support 12 et la deuxième couche d'oxyde enterrée 14 sont réalisées en une seule deuxième couche de support combinée 15 qui réalise les fonctions de support (durant les étapes de fabrications) et d'arrêt de la gravure de la couche 20. Une telle couche combinée 15 peut par exemple être en aluminium. La plaquette peut également comprendre encore d'autres couches, par exemple encore une autre couche de support et/ou une autre couche de travail pour former des composants horlogers multi-niveaux dans plusieurs couches.

Le dessin n'est pas à l'échelle mais, de préférence, l'épaisseur de la couche de travail 30 correspond généralement à l'épaisseur maximale e₉₀ des composants horlogers (sachant que cette épaisseur peut diminuer légèrement suite à un cycle d'oxydation-désoxydation durant le procédé de fabrication). Selon un exemple, l'épaisseur de la couche de travail 30 est d'environ 120 µm. La couche d'oxyde enterrée 40 peut avoir une épaisseur e₄₀ de 0.5-2 µm. Avantageusement, la première couche de support 20 peut être relativement mince par rapport à la deuxième couche de support 12. Par exemple, la première couche de support 20 peut avoir une épaisseur inférieure ou égale à 50 µm, de préférence inférieure ou égale à 25 µm, et encore plus privilégiée inférieure ou égale à 10 µm. La première couche de support 20 peut également avoir une épaisseur d'au moins 3 µm et de préférence d'au moins 5 µm. Selon des exemples, l'épaisseur la première couche de support est égale à 5 µm, 10 µm, 15 µm, 20 µm, 25 µm, ou 30 µm, et elle peut bien entendu tomber dans une plage entre deux de ces valeurs. A titre d'exemple, la couche de support 12 peut avoir une épaisseur allant jusqu'à 500 µm voire 1 mm, avec de préférence une épaisseur d'au moins 150 µm. Quand elle est présente, la deuxième couche enterrée 14 peut avoir une épaisseur allant de 0.5 à 2 µm.

La première couche de support 20 et la couche de travail 30 peuvent être du même type de silicium ou de types différents - par exemple de silicium monocristallin avec une orientation cristalline quelconque, du silicium polycristallin, ou du silicium amorphe. Ces couches de silicium 20, 30 (et notamment la couche de travail 30) peuvent être dopés type N ou type P. Par exemple, l'utilisation d'un silicium fortement dopé peut être avantageuse pour la fabrication des résonateurs car, par exemple, on constate une déformation moindre de la matière dopée lors de l'oxydation thermique sous certaines conditions.

La plaquette multi-couches 10 comprend un côté inférieur 10A (voire le côté couche de support 12), et c'est depuis ce côté que la plaquette 10 repose normalement sur des équipements lors des différents étapes de microfabrication. La plaquette 10 comprend également un côté supérieur 10B (voire le côté couche de travail 30), et c'est depuis ce côté que les étapes de microfabrication pour former les composants horlogers sont généralement effectuées.

Dans la figure 1b, une étape de lithographie commence avec la formation d'une couche d'oxyde de silicium 50 sur la surface supérieure de la couche de travail 30. Par « lithographie », on entend l'ensemble des opérations permettant de transférer une image ou un motif sur ou au-dessus de la plaquette 10 vers cette dernière. Dans ce mode de réalisation, la couche d'oxyde 50 a une épaisseur e₅₀ plus importante que l'épaisseur e₄₀ de la couche d'oxyde enterrée 40, par exemple une épaisseur de 1-6 µm. La couche d'oxyde 50 peut être formée par oxydation thermique ou alternativement par un dépôt de type PVD, CVD, ou ALD. De manière générale, la formation de la couche d'oxyde 50 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche de travail 30.

A la figure 1c, la couche d'oxyde 50 est recouverte d'une couche de résine 60, qui est typiquement une résine photosensible de type positif ou négatif. Cette couche de résine peut avoir une épaisseur comprise entre 0.5 - 12 µm, à titre purement illustratif. Par la suite, dans la figure 1d, la couche de résine 60 est structurée de préférence en utilisant une étape de photolithographie avec une source de lumière ultraviolette 80 ainsi que, par exemple, un masque d'exposition 70 tel qu'un photomasque. Un système de stepper et réticule peut également être utilisé pour l'étape de photolithographie, ou alors un système d'écriture directe (i.e. sans photomasque) tel qu'un système de lithographie par laser ou par faisceau d'électrons (la lithographie e-beam). Dans l'exemple illustré, la couche 60 comprend une résine photosensible de type positif dont les parties 60E de la résine qui sont exposées à la lumière deviennent solubles dans un révélateur et les parties non exposées restent insolubles.

Dans la figure 1e, la couche de résine 60 est ouverte après avoir été développée par un révélateur, notamment un solvant qui élimine les parties exposées 60E de la résine par voie chimique. Ensuite, à la figure 1f, les parties de la couche d'oxyde 50 qui se trouvaient en dessous des parties exposées 60E de la résine sont aussi retirées de la surface de la couche de travail 30, et la couche d'oxyde 50 est donc structurée sur la surface de la couche de travail. Cette étape peut être réalisée par exemple en employant une gravure plasma sélective directionnelle utilisant un ou plusieurs gaz fluorés (tels que CHF₃, C₄F₈, et/ou SF₆) en combinaison avec au moins un des gaz He et/ou H₂ en fonction des sélectivités et des vitesses de gravure souhaitées. L'utilisation d'une technique de gravure directionnelle est généralement privilégiée lors de cette étape car elle est plus précise, mais alternativement une gravure à base de vapeur d'acide hydrofluorique (HF) ou à base d'une solution liquide tampon de type BHF peut aussi être utilisée.

A l'étape illustrée à la figure 1g, la partie restante de la couche de résine 60 peut être éliminée, par exemple en utilisant un plasma dioxygène (O₂), mais optionnellement on peut garder la partie restante de cette couche comme masque en plus de la couche d'oxyde 50. Les étapes des figures 1a - 1g servent alors à former une couche en oxyde de silicium structurée 50 sur la surface supérieure de la couche de travail 30, cette couche ayant une épaisseur e₅₀ plus importante que l'épaisseur e₄₀ de la couche d'oxyde enterrée 40. Selon des variantes, la couche en oxyde de silicium structurée peut être formée autrement.

Ensuite, à l'étape de la figure 1h, des motifs sont gravés dans la couche de travail 30 au travers de la couche en oxyde de silicium 50 structurée, et optionnellement la couche de résine restante 60, pour former le composant horloger 90 (ou du moins une ébauche du composant). En général, les motifs gravés s'étendent sur toute l'épaisseur de la couche de travail 30 tel qu'illustré, et à cette fin la couche d'oxyde enterrée 40 peut agir comme un stop lors de la gravure. De cette manière, l'épaisseur maximum des composants horlogers 90 correspond généralement à l'épaisseur de la couche de travail 30. Comme illustré, à la fin de cette étape on obtient une couche de travail structurée 30' avec des régions 35 se trouvant autour de la structure du composant dans lesquelles le matériau de la couche de travail 30 a été éliminé, exposant ainsi des parties de la couche d'oxyde enterrée 40 en dessous de ces régions éliminées 35.

La gravure à l'étape de la figure 1h peut notamment être effectuée par une technique de gravure ionique réactive profonde (également connue sous l'acronyme DRIE pour « Deep Reactive Ion Etching » en anglais), par exemple en utilisant le SF₆ comme gaz réactif pour graver le silicium de la couche device et en utilisant le gaz C₄F₈ périodiquement comme gaz de passivation pour la protection des surfaces des flancs latéraux 95 du composant horloger. La gravure DRIE permet de former des trous et des tranchées profondes dans la couche 30 avec un rapport largeur/hauteur important, ce qui est bien adapté pour des composants micromécaniques comme des composants horlogers. De manière connue, l'utilisation du gaz C₄F₈ comme gaz de passivation produit une couche de fluoropolymère sur les surfaces des flancs latéraux 95. Une telle couche, qui a typiquement une épaisseur de 0.1 à 5 µm, peut être enlevée des flancs par une technique appropriée par exemple en utilisant un plasma dioxygène (O₂). Alternativement, la structuration de la couche de travail peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Cependant, la résolution dimensionnelle des structures gravées est généralement moins bonne avec une structuration par gravure humide/chimique qu'avec une gravure ionique réactive profonde.

Comme indiqué ci-dessus, il est également possible pour la partie restante de la couche de résine 60 d'être toujours présente lors de l'étape de gravure profonde (DRIE ou autre) de la couche de travail 30. Cette partie restante de la couche de résine peut être retirée après la gravure, et dans ce cas la couche de travail 30 est gravée au travers des deux couches 50, 60 structurées. A titre d'exemple, une résine positive peut être retirée par des solvants de type acétone ou diméthylsulfoxyde (DMSO) ou avec un plasma O₂ soit avant soit après l'étape de gravure. Pour une résine négative comme le SU-8, un plasma CF₄/O₂ peut être employé pour son retrait.

Les figures 1i-1m illustrent l'approche de libération des composants horlogers 90 selon ce mode de réalisation de l'invention. A la figure 1i, une couche d'oxyde 55 de silicium (SiO₂) est de préférence formée sur l'ensemble des surfaces en silicium exposées de la plaquette 10, incluant les surfaces des flancs 95 du composant horloger. De préférence, cette couche d'oxyde 55 est formée par oxydation thermique et donc se forme également sur tout le silicium exposé de la plaquette 10 incluant la surface inférieure de la couche de support 12 si elle est en silicium, comme illustré. La couche d'oxyde 55 rejoint les couches d'oxydes 50 et 40 déjà présentes sur les surfaces supérieure et inférieure (en dessous) du composant horloger 90, et ces dernières couches peuvent devenir légèrement plus épaisses durant l'oxydation thermique, du moins où la couche d'oxyde enterrée 40 est exposée en dessous des régions 35. L'épaisseur de la couche d'oxyde 55 peut varier mais de préférence elle est comprise entre 0.05 et 2µm.

La formation de la couche d'oxyde 55 sert notamment à protéger les surfaces des flancs 95 des composants horlogers 90 ainsi que d'autres endroits de la plaquette où le silicium est exposé lors des étapes de fabrication suivantes du procédé. Alternativement, une couche de protection en oxyde de silicium (SiO₂) ou en un autre matériau (par exemple une résine, un polymère, ou un autre oxyde comme l'Al₂O₃) peut être sélectivement formée sur ces surfaces et notamment sur les surfaces des flancs 95. Un tel dépôt sélectif peut être réalisé à titre d'exemple par une technique à base de l'ALD (en anglais « atomic layer de position ») tel que décrit dans le document Taguhi Yeghoyan, Vincent Pesce, Moustapha Jaffal, Gauthier Lefevre, Rémy Gassilloud, Nicolas Posseme, Marceline Bonvalot, Christophe Vallée; Low temperature Topographically Selective Deposition by Plasma Enhanced Atomic Layer Deposition with ion bombardment assistance. J. Vac. Sci. Technol. A 1 May 2021; 39 (3): 032416 ou le document A. Chaker, C. Vallee, V. Pesce, S. Belahcen, R. Vallat, R. Gassilloud, N. Posseme, M. Bonvalot, A. Bsiesy; Topographically selective deposition. Appl. Phys. Lett. 28 January 2019; 114 (4): 043101. D'autres techniques de dépôt sélectifs pourraient également être employées. Le dépôt sélectif d'une couche de protection peut aussi être effectué ultérieurement, après une étape de gravure directionnelle décrite ci-dessous en association avec la figure 1j. Cependant, un dépôt sélectif est généralement plus compliqué à réaliser sur les surfaces verticales des flancs 95 des composants horlogers, et pour cette raison la formation de la couche d'oxyde 55 par oxydation thermique reste privilégiée.

Comme décrit ci-dessus, si une gravure DRIE utilisant un gaz fluoré tel que le C₄F₈ a été employée à l'étape de la figure 1h, une couche de fluoropolymère se forme généralement sur les surfaces des flancs latéraux 95. Selon une variante, on peut garder et ne pas enlever cette couche fluoropolymère après la gravure DRIE de cette étape de la figure 1h, et cette couche fluoropolymère peut par la suite servir comme une couche de protection de ces flancs pour les étapes qui suivent. Une telle couche de protection peut avantageusement être utilisée, par exemple, quand une gravure ultérieure de la première couche de support 20 (telle que décrite ci-dessous en lien avec les figures 1k et 1l) est réalisée par une gravure en phase vapeur à base de difluorure de xénon (XeF₂), car une couche fluoropolymère est typiquement hautement sélective par rapport à cet agent de gravure.

Ensuite, à la figure 1j, une gravure qui est de préférence directionnelle, notamment de type DRIE ou ICP-RIE (« Inductively Coupled Plasma - Reactive Ion Etching » en anglais), est effectuée pour graver les couches d'oxyde 40 et 50 de la plaquette jusqu'au point auquel des régions 45 de la couche d'oxyde enterrée 40 se trouvant en dessous des régions 35 sont éliminées. Cette gravure directionnelle a lieu dans le sens vertical de la plaquette 10 depuis son côté 10b comme illustré par les flèches dans la figure 1j et agit sur toutes les surfaces perpendiculaires au flux de gravure. Puisque dans ce mode de réalisation l'épaisseur de la couche d'oxyde 50 est plus importante que l'épaisseur de la couche d'oxyde enterrée 40, en contrôlant les paramètres et la durée de la gravure, une couche d'oxyde amincie 50' (avec une plus faible épaisseur que la couche 50 initiale) est toujours présente sur la surface supérieure de la couche de travail structurée 30' à la fin de cette étape de gravure. La gravure étant directionnelle, les couches d'oxyde 55 sur les surfaces verticales de la couche de travail structurée 30', et notamment sur les surfaces des flancs 95 des composants horlogers, sont peu exposées aux ions réactifs durant la gravure et donc sont peu, voire pas, gravées, la gravure directionnelle agissant surtout sur les couches d'oxydes 40, 50 qui sont disposées horizontalement sur la plaquette 10. Pour cette raison, la présence d'une couche de protection sur les surfaces des flancs 95 n'est pas indispensable durant la gravure directionnelle, même si cela est privilégié.

Une gravure plasma sélective directionnelle utilisant au moins un gaz fluoré (tel que CHF₃, C₄F₈, et/ou SF₆) en combinaison avec au moins un des gaz He et/ou H₂ peut être employée lors de l'étape de la figure 1j en fonction des sélectivités et des vitesses de gravure voulues. Avantageusement, cette étape de gravure directionnelle peut être réalisée sans masque d'exposition rendant cette étape relativement rapide et économique. A la fin de cette étape, on obtient une couche d'oxyde enterrée ajourée 40' avec des régions 45 (se trouvant en dessous des régions 35) dans lesquelles l'oxyde de la couche enterrée 40 a été éliminé exposant la surface supérieure de la première couche de support 20.

Selon une variante, une gravure plasma sélective directionnelle à l'instar de celle effectuée à l'étape de la figure 1j peut également être effectuée avant l'étape de la figure 1i. Une telle gravure directionnelle préalable sert à enlever (ou du moins à réduire en épaisseur) les parties de la couche d'oxyde enterrée 40 se trouvant en dessous des régions 35 avant l'étape d'oxydation thermique à l'étape de la figure 1i. Dans cette variante, il peut être privilégié pour la partie restante de la couche de résine 60 d'être toujours présente durant l'étape de gravure profonde de la figure 1h et cette étape de gravure directionnelle préalable afin que la couche d'oxyde 50 sur la surface supérieure de la couche de travail structurée 30' n'est pas gravée durant la gravure directionnelle préalable. Il n'est pas nécessaire que la couche d'oxyde 50 a une épaisseur plus importante que l'épaisseur de la couche d'oxyde enterrée 40 dans ce mode de réalisation, et la couche de résine peut être enlevée après l'étape de gravure directionnelle préalable. Par la suite, on peut réaliser l'étape d'oxydation thermique de la figure 1i pour former une couche d'oxyde 55 de silicium (SiO₂) sur l'ensemble des surfaces en silicium exposées de la plaquette 10 (incluant au fond des régions 35), et après une autre étape de gravure plasma sélective directionnelle à l'étape de la figure 1j a lieu comme décrit ci-dessus. L'épaisseur de l'oxyde se trouvant en dessous des régions 35 qui doit être enlevée durant cette deuxième étape de gravure plasma sélective directionnelle est alors moins importante selon cette variante. Cette variante peut en outre être appliquée dans le cadre de la libération de composants horlogers fabriqués dans une plaquette SOI conventionnelle (c'est-à-dire avec juste trois couches incluant une seule couche de support) comme décrit dans la demande de brevet européen no. EP24207484 déposée au nom de la titulaire de la présente demande.

Selon une autre variante, si la couche de protection sur les surfaces des flancs 95 comprend un matériau autre que l'oxyde de silicium (SiO₂), la gravure effectuée lors de l'étape de la figure 1j n'a pas forcement besoin d'être directionnelle, et une gravure contrôlée à base de vapeur d'acide hydrofluorique (HF) ou à base d'une solution liquide tampon de type BHF peut être utilisée à la place, afin d'ouvrir uniquement la couche enterrée en SiO₂ sans éliminer la couche oxyde 50.

Si une couche de protection n'a pas été formée sur les surfaces des flancs 95 des composants horlogers 90 avant la gravure directionnelle des couches d'oxyde 40, 50, une telle couche de protection peut être déposée sélectivement sur ces flancs après cette gravure directionnelle des couches d'oxyde 40, 50. Dans ce cas, il est important que le dépôt sélectif ne couvre pas les régions exposées de la couche de support 20 en dessous des régions éliminées 45 de la couche d'oxyde enterrée.

A la figure 1k, on commence une étape de gravure du silicium de la première couche de support 20 afin de la structurer en gravant une portion de cette couche en dessous des composants horlogers 90. Plus particulièrement, la couche de support 20 est gravée où elle est exposée en dessous des régions éliminées 45 de la couche d'oxyde enterrée. Selon la variante illustrée, une gravure humide/chimique anisotrope est utilisée à cette étape pour former des régions gravées 22 dans la couche de support 20 où le silicium a été éliminé. La gravure anisotrope permet d'éliminer le silicium plus rapidement dans certaines directions dans chaque région gravée 22, selon les orientations cristallines de la plaquette. Les surfaces des flancs dans les régions gravées 22 forment donc un angle et en général cet angle varie en fonction de différents paramètres incluant notamment l'orientation cristalline du silicium. Un bain d'hydroxyde de potassium (KOH) peut être utilisé pour cette gravure anisotrope, mais alternativement on peut également utiliser par exemple un bain de d'hydroxyde de tétraméthylammonium (TMAH). Selon une autre variante pour l'étape de la figure 1k, on peut utiliser une technique de gravure isotrope pour attaquer le silicium de la couche de support 20, par exemple une gravure en phase vapeur à base de difluorure de xénon (XeF₂). Une telle gravure isotrope élimine le silicium plus ou moins uniformément dans toutes les directions créant ainsi des régions gravées 22 de la couche de support ayant la forme (en section) de demi-cercles en dessous des régions éliminées de la couche d'oxyde enterrée.

Selon encore une autre variante particulièrement avantageuse pour attaquer le silicium de la couche de support 20 à l'étape de la figure 1k, on peut utiliser une technique de gravure isotrope avec un plasma à base d'hexafluorure de soufre (SF₆). Dans ce cas, la vitesse de réaction durant la gravure est très rapide et les surfaces gravées sont relativement propres et lisses. De plus, une telle étape peut être effectuée dans la même chambre que l'étape de gravure DRIE utilisée pour former les composants horlogers (voire l'étape de la figure 1h), notamment quand un plasma SF₆ est aussi utilisé pour cette dernière étape. Par ailleurs, durant l'attaque du silicium de la couche de support 20, des fissures peuvent apparaitre dans les couches de protection (en SiO₂ ou un autre matériau) sur les composants horlogers et notamment sur les arrêtes de ces composants. Cependant, en utilisant un plasma à base de SF₆, les radicaux fluors créés par le plasma sont très majoritairement bloqués avant de pouvoir pénétrer à l'intérieur de ces fissures, ce qui empêche toute attaque des couches de protection lors de l'étape de la figure 1k.

De préférence, et comme illustré dans la figure 1l, l'étape de gravure de la figure 1k continue afin que les régions gravées 22 dans lesquelles le silicium de la première couche de support a été éliminé s'unissent pour former une seule région éliminée 24 s'étendant en dessous de chaque composant horloger 90. De préférence, la deuxième couche enterrée 14 (ou si elle n'est pas présente une deuxième couche de support 15) sert à arrêter la gravure de la première couche de support 20 durant cette l'étape afin qu'au moins une partie de chaque région éliminée 24 s'étend sur toute l'épaisseur de la première couche de support 20. On obtient donc une première couche de support structurée 20' comprenant ces régions éliminées 24. Avantageusement, quand la première couche de support 20 est relativement mince, c'est-à-dire qu'elle a une épaisseur inférieure ou égale à 50 µm (de préférence inférieure ou égale à 25 µm, et encore plus privilégiée inférieure ou égale à 10 µm), la gravure anisotrope ou isotrope des régions éliminées 24 peut être très rapide en dessous des composants horlogers 90. Durant la gravure plasma ou gazeuse de la première couche de support il y a généralement une quantité limitée de réactif, mais avec une couche de support 20 mince il y a moins de matière à graver dans le sens vertical de la plaquette, et la gravure a surtout lieu dans les directions latérales en dessous des composants horlogers puisque la gravure est confinée par la couche enterrée 14 (ou par une couche combinée 15 à sa place). Cela permet de rapidement graver des régions éliminée 24 en dessous des composants horlogers en minimisant en même temps le risque de graver ou endommager la couche de protection sur les surfaces des flancs 95 des composants. De cette manière, selon ce mode de réalisation privilégié, sensiblement toute l'épaisseur de la première couche de support 20 est éliminée dans les régions éliminées 24.

Selon le mode de réalisation privilégié dans lequel la réalisation de la couche d'oxyde 55 durant l'étape de la figure 1i est par une oxydation thermique, la gravure du silicium aux étapes des figures 1k et 1l attaque la couche de support 20 uniquement au travers des régions éliminées de la couche d'oxyde enterrée ajourée 40', les autres surfaces de la plaquette étant protégées par la couche d'oxyde 55, particulièrement la couche d'oxyde en face arrière de la deuxième couche de support 12 (voire du côté 10A de la plaquette).

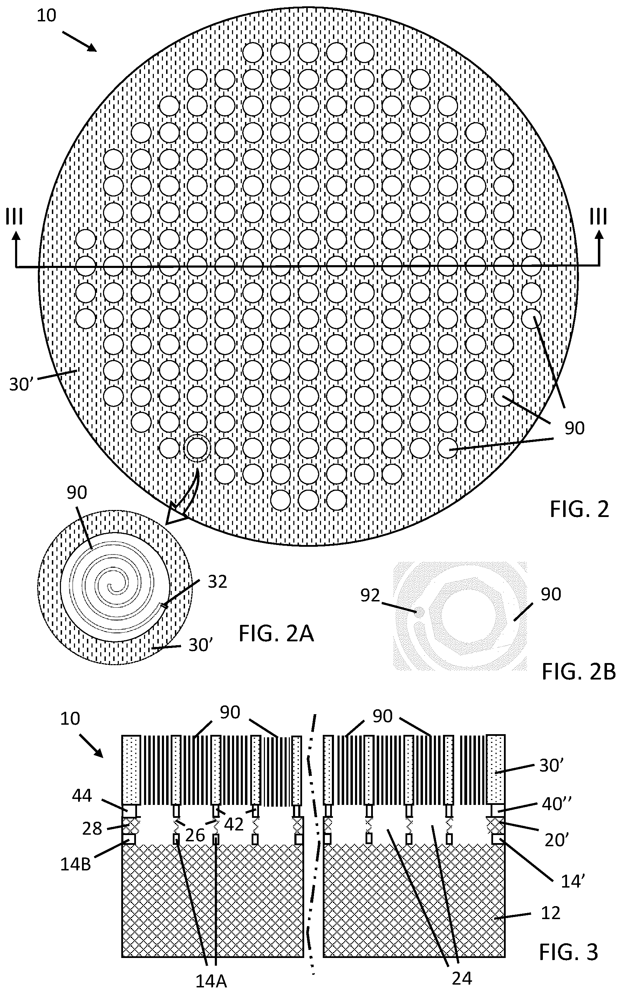

Finalement, pour compléter la libération des composants horlogers, on effectue à la figure 1m une étape de désoxydation, ce qui élimine les couches d'oxyde 50' et 55 ainsi que les parties de la première couche d'oxyde enterrée ajourée 40' restant entre chaque région 24 et le ou les composants horlogers 90 au-dessus de cette région. De plus, des parties de la deuxième couche enterrée 14 (qui est également en oxyde de silicium selon ce mode de réalisation) en dessous de chaque région 24 sont également éliminées durant cette étape. Cette étape de désoxydation peut être réalisée, par exemple, par une gravure par voie humide ou en phase vapeur ou gaz, par exemple à base d'acide fluorhydrique (HF) ou de gaz HF anhydre. A la fin de cette étape, on obtient donc une première couche enterrée structurée 40" dont une partie importante de la couche a été éliminée, mais qui comprend des parties 42, 44 (voir la figure 3) toujours présentes en dehors des zones des composants horlogers 90. Similairement, on obtient une deuxième couche enterrée structurée 14' qui comprend des parties 14A, 14B (voir la figure 3) toujours présentes en dehors des zones des composants horlogers 90. Ces parties subsistantes 42, 44, 14A et 14B de ces couches d'oxyde enterrées structurée 40", 14' gardent la liaison entre la couche de travail structurée 30' et la deuxième couche de support 12 par le biais des parties restantes 26, 28 (voir la figure 3) de la première couche de support structurée 20'.

Si la couche de protection sur les surfaces des flancs 95 comprend un matériau autre que l'oxyde de silicium (SiO₂), cette couche de protection pourrait être enlevée ou éliminée avant ou après l'étape de la figure 1m par une technique appropriée. Par exemple, dans le cadre d'une résine ou d'une couche de fluoropolymère, on peut utiliser un plasma dioxygène (O2) pour enlever une telle couche de protection.

Les composants horlogers 90 sont alors libérés sur la plaquette 10 permettant la réalisation des étapes de fabrication subséquentes, comme le sera décrit ci-dessous, sur la quasi-totalité de la surface externe de ces composants. A cette fin, après la libération, les composants horlogers 90 ne sont supportés structurellement que par des ponts de liaison (illustrés schématiquement par le trait 32 dans la figure 1m; en réalité le pont s'étend sur toute l'épaisseur du composant) dans la couche de travail structurée 30'. De cette manière, les composants 90 restent attachés aux parties subsistantes de la couche de travail structurée 30'. Cela est illustré dans la figure 2 qui est une vue de dessus de la plaquette 10 et notamment de la couche de travail structurée 30' après les étapes de fabrication des figures 1a-1m selon un mode de réalisation. A noter que dans la figure 2 les composants horlogers 90 se trouvent dans des zones de la couche qui sont simplement illustrés par des cercles vides afin de ne pas surcharger le dessin, mais la figure 2A donne une vue magnifiée d'une de ces zones montrant à titre d'exemple un spiral comme le composant horloger et un pont de liaison 32.

Par ailleurs et tel qu'illustré à la figure 2B, pour réduire le temps de gravure de la première couche de support 20 aux étapes des figures 1k et 1l, il est également possible de former un trou traversant 92 dans une zone large du composant horloger 90. Dans l'exemple illustré, le trou 92 se trouve dans une zone proche d'une ouverture centrale du spiral. En gravant le trou durant la formation des composants horlogers à l'étape de la figure 1h, le temps de gravure total en dessous de cette zone large du spiral est réduit. Bien entendu, il est important d'assurer que tout trou 92 n'altère pas les fonctions mécaniques et chronométriques du spiral ou d'un autre type de composant horloger. Cette approche de graver un trou traversant non fonctionnel dans une zone large du composant horloger pour accélérer le temps de gravure d'une couche située en dessous de la couche de travail peut également être utilisée dans le cadre d'autres techniques de libération des composants horlogers. Par exemple, on peut employer cette approche pour graver plus rapidement la couche d'oxyde enterrée située directement en dessous de la couche de travail dans une plaquette SOI simple durant la technique de libération décrite dans le document WO2019180596.

La figure 3 est également une vue en section selon la ligne III-III de la figure 2 montrant une région 24 libérant chacun des composants horlogers 90 par le dessous. Malgré cette libération, la couche de travail structurée 30' est toujours soutenue par la deuxième couche de support 12 de la plaquette 10, ces deux couches étant liées ensemble par le biais des parties subsistantes 42, 44 de la première couche d'oxyde enterrée structurée 40", les parties subsistantes 26, 28 de la première couche de support structurée 20', et les parties subsistantes 14A, 14B de la deuxième couche d'oxyde enterrée structurée 14'. Comme illustré aux figures 2 et 3, les parties subsistantes 44, 28, et 14B des couches structurées 40", 20', 14' situées à la périphérie de la plaquette 10 ont de préférence une largeur plus importante que les parties subsistantes 42, 26, et 14A se trouvant entre les composants horlogers 90.

Dans le mode de réalisation décrit ci-dessus, chaque composant horloger 90 de la plaquette a sa propre région 24, c'est-à-dire une région 24 dédiée à ce composant, qui s'étend uniquement en dessous de ce composant. Selon un autre mode de réalisation, une seule région 24 peut s'étendre en dessous de plusieurs composants de la plaquette, les couches structurées 40", 20', 14' n'ayant pas des parties subsistantes 42, 26, 14A entre des composants situés au-dessus d'une même région. La plaquette peut même avoir une seule région 24 qui s'étend en dessous de tous les composants de la plaquette, et dans ce cas c'est uniquement des parties subsistantes périphériques 44, 28, 14B de ces couches structurées 40", 20', 14' qui maintiennent la liaison entre la couche de travail structurée 30' et la deuxième couche de support 12.

Après l'étape de gravure de la couche de travail pour former les composants horlogers 90 (cf. la figure 1h), il est connu que les surfaces des flancs 95 des motifs structurés des composants 90 possèdent une rugosité relativement importante. Dans le cadre d'une gravure de type DRIE, cette rugosité se manifeste en forme d'une surface 95' avec des ondulations souvent appelées « scallops » avec des pics 96 comme illustré à la partie gauche de la figure 1h. En fait, lors d'une gravure DRIE on alterne entre une phase de gravure du silicium et une phase de passivation ce qui résulte en la surface ondulée 95'. Après une gravure DRIE ou un autre type de gravure, la rugosité des surfaces des flancs 95 peut être réduite par une étape de lissage, ce qui renforce ces surfaces mécaniquement en limitant les amorces de rupture. Ce lissage peut notamment être effectué par une étape d'oxydation thermique suivie par une étape de désoxydation, constituée par exemple d'une gravure par voie humide ou en phase vapeur, par exemple à base d'acide fluorhydrique (HF) ou de gaz HF anhydre. De manière connue, lors de l'oxydation thermique, le silicium à la surface des flancs 95 est consommée, et cette consommation est généralement plus rapide vers les pics 96, ce qui résulte en une surface de silicium plus lisse après la désoxydation.

Comme mentionné ci-dessus, de préférence à l'étape de la figure 1i on forme la couche d'oxyde 55 sur les surfaces des flancs 95 du composant 90 par oxydation thermique. Cela permet de réaliser un lissage des flancs des composants horlogers durant la libération. Plus précisément, lors de l'étape de désoxydation à la figure 1m, on réalise non seulement la libération des composants horlogers 90 dans la plaquette 10 mais en même temps un lissage des surfaces des flancs 95 de ces composants sur la plaquette. En réalisant le lissage et la libération avec une seule étape de désoxydation selon ce mode de réalisation de la présente invention, le nombre d'étapes dans le procédé de fabrication des composants horlogers 90 dans la plaquette 10 est aussi réduit.

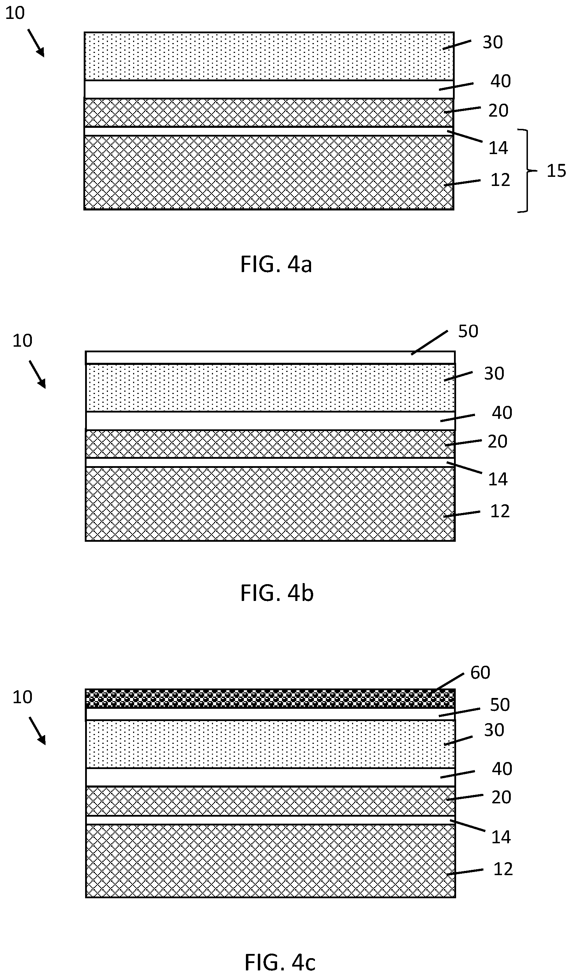

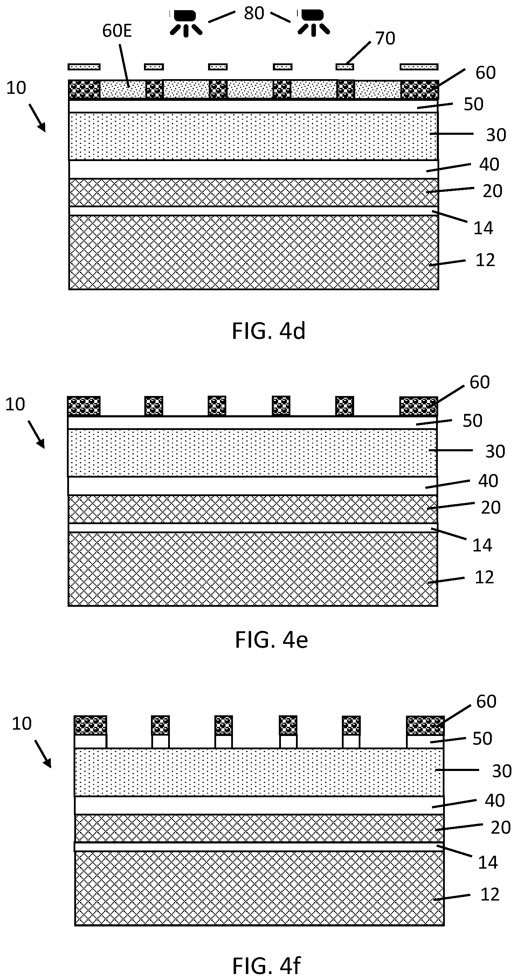

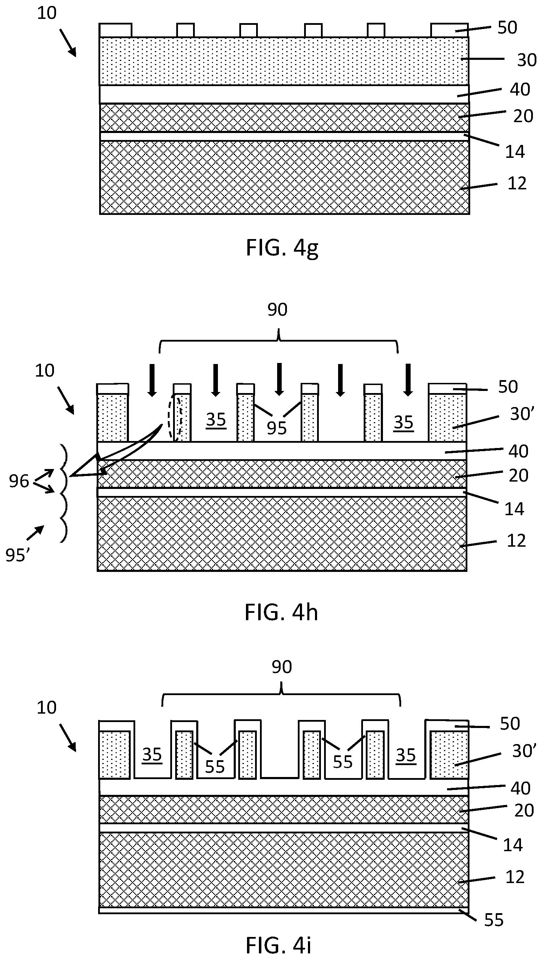

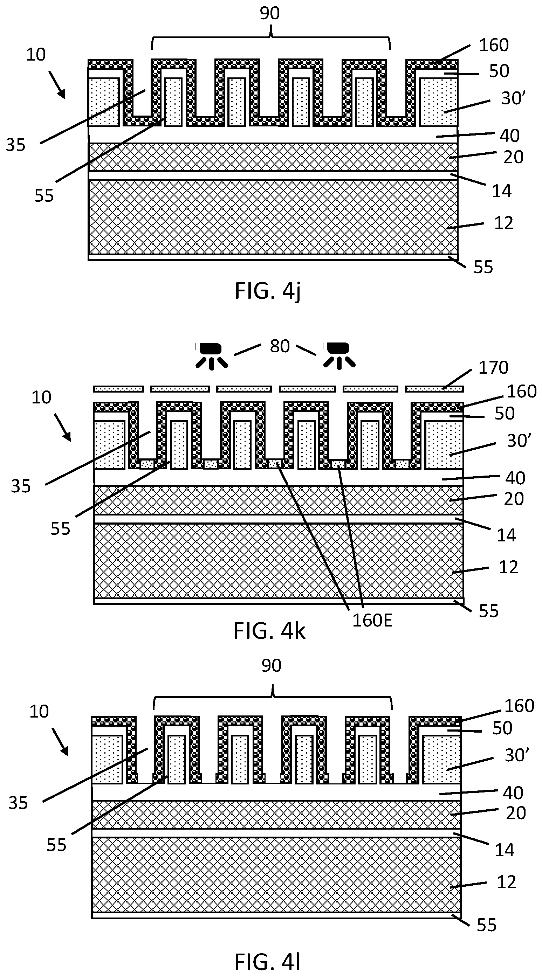

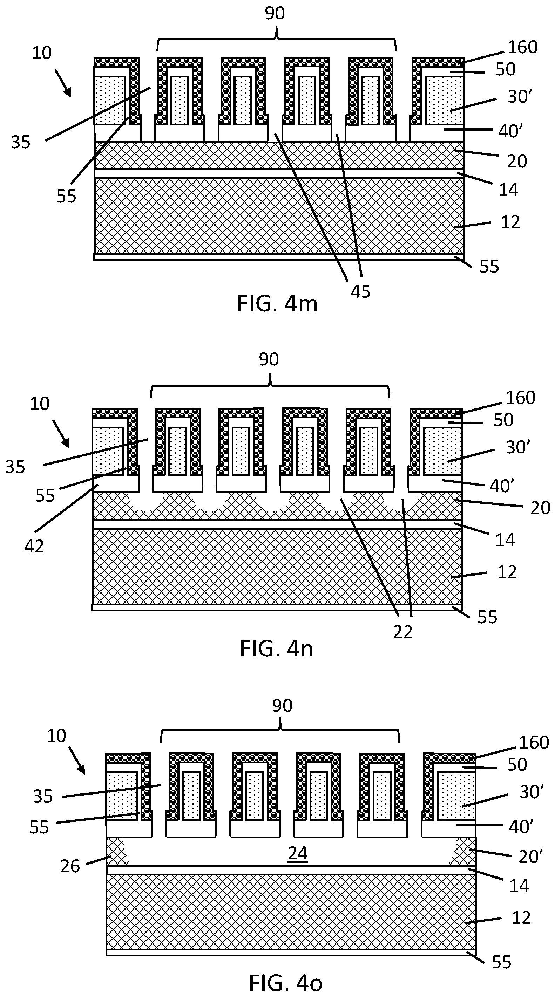

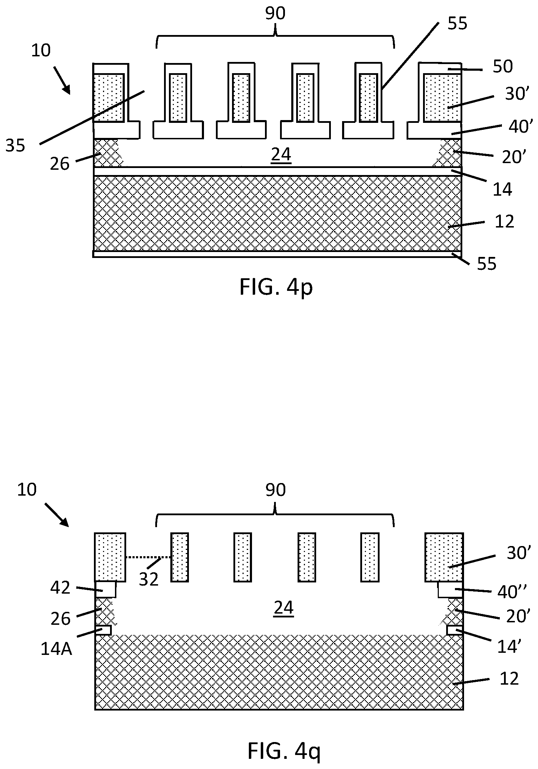

Les figures 4a-4q illustrent une série d'étapes de fabrication schématiques d'un composant horloger dans une plaquette multi-couches selon un autre mode de réalisation de l'invention, la plaquette 10 de départ étant identique. Comme pour le mode de réalisation de la figure 1, plusieurs composants horlogers peuvent être fabriqués dans la plaquette en même temps, et les vues de la figure 4 sont isolées sur un seul composant pour des raisons de simplicité.

Les étapes des figures 4a-4i pour former les composants horlogers 90 correspondent aux étapes des figures 1a-1i à l'exception que selon ce mode de réalisation il n'est pas nécessaire que la couche d'oxyde 50 a une épaisseur plus importante que l'épaisseur de la première couche d'oxyde enterrée 40. Pour le reste, la description ci-dessus en lien avec les figures 1a-1i s'applique et ne sera pas répétée ici.

Les figures 4i-4q illustrent l'approche de libération des composants horlogers 90 selon ce mode de réalisation. Comme dans le premier mode de réalisation de la figure 1, à la figure 4i, une couche d'oxyde 55 de silicium (SiO₂) est de préférence formée sur les surfaces des flancs 95 du composant horloger et de préférence sur l'ensemble de chacune de ses surfaces flancs. A la prochaine étape de la figure 4j, les parties exposées de la première couche d'oxyde enterrée 40 et de la couche de travail structurée 30' (qui est déjà recouverte par les couches d'oxydes 50, 55) sont recouvertes d'un matériau de masque, qui est de préférence une couche de résine 160 mais peut alternativement comprendre un autre matériau au moins hautement sélectif pour l'agent de gravure tel qu'un métal (par exemple, aluminium, nickel, chrome, ou platine), un oxyde (MgO, ZnO, TiO₂, ZrO₂, ou Al₂O₃), ou un nitrure (AIN ou Si₃N₄). La résine 160 est de préférence une résine photosensible de type positif, et elle peut avoir une épaisseur comprise entre 0.5 - 6µm, à titre illustratif. Le dépôt de la résine 160 est de préférence effectué par un revêtement de pulvérisation (en anglais « spray coating ») mais il peut également être réalisé par un trempage (an anglais « dip coating »), par une enduction centrifuge (en anglais « spin coating »), par un recuit sous vide, ou par un dépôt sous vide avec de la poudre. Selon une variante, la formation de l'oxyde 55 à l'étape de la figure 4i peut également être écartée, et la résine 160 peut être déposée directement sur la couche de travail structurée 30' (avec ou sans la couche d'oxyde 50) qui résulte après l'étape de la figure 4h.

Par la suite, dans la figure 4k, la couche de résine 160 est structurée, de préférence en utilisant une étape de photolithographie avec une source de lumière ultraviolette 80 ainsi que, par exemple, un masque d'exposition 170 tel qu'un photomasque. Un système de stepper et réticule peut également être utilisé pour l'étape de photolithographie ou encore un système d'écriture direct. Dans l'exemple illustré, la couche 160 comprend une résine photosensible de type positif dont les parties 160E de la résine qui sont exposées à la lumière deviennent solubles dans un révélateur et les parties non exposées restent insolubles. Selon d'autres modes de réalisation, la résine peut être structurée par un faisceau laser ou d'électrons.

Comme illustré dans la figure 4k, les parties exposées 160E de la résine 160 se trouvent sur la première couche d'oxyde enterrée 40 dans les régions éliminées 35 de la couche de travail structurée 30' entre les structures du composant horloger 90. De préférence, les parties exposées 160E de la résine 160 sur la première couche d'oxyde enterrée 40 se trouvent vers le milieu des régions éliminées 35 mais ne s'étendent pas vers les bords de ces régions près des surfaces flancs 95 des composants horlogers 90 afin d'éviter le retrait de la résine sur ces surfaces flancs.

Dans la figure 4l, la couche de résine 160 est ouverte (voire elle est structurée) après avoir été développée par un révélateur, notamment un solvant qui élimine les parties exposées 160E de la résine sur la première couche d'oxyde enterrée 40 par voie chimique. Ensuite, à la figure 4m, les parties de la première couche oxyde enterrée 40 qui se trouvaient en dessous des parties exposées 160E de la résine sont aussi retirées de la surface supérieure de la première couche de support 20 de la plaquette 10, par exemple en employant une gravure humide ou à base de vapeur d'acide hydrofluorique (HF). Alternativement, une gravure DRIE de la couche d'oxyde de silicium peut être employée, et selon encore une autre alternative on peut utiliser une gravure plasma sélective, par exemple avec les gaz CH₄/O₂ ou C₄F₈/He/H₂, pour attaquer la première couche d'oxyde enterrée 40. Après cette étape, on obtient une première couche d'oxyde enterrée ajourée 40' avec des régions 45 dans lesquelles l'oxyde de la première couche enterrée a été éliminé, exposant ainsi la première couche de support 20 en dessous de ces régions éliminées 45.

La surface supérieure de la première couche de support 20 étant maintenant exposée en dessous de ces régions éliminées 45, à l'étape de la figure 4n, on commence une étape de gravure du silicium de cette couche pour structurer une portion de la couche 20 en dessous des composants horlogers 90. Comme dans le premier mode de réalisation, différents types de gravure peuvent être utilisés durant cette étape incluant une gravure humide anisotrope de cette étape utilise un bain d'hydroxyde de potassium (KOH), une gravure en phase vapeur à base de difluorure de xénon (XeF₂), ou une gravure plasma à base d'hexafluorure de soufre (SF₆).

De préférence, l'étape de gravure de la figure 4n continue afin que les régions gravées 22 dans lesquelles le silicium de la première couche de support a été éliminé s'unissent pour former une seule région éliminée 24 s'étendant en dessous de chaque composant horloger 90 comme illustré dans la figure 4o. Comme dans le mode de réalisation de la figure 1, la première couche de support 20 est de préférence relativement mince (par exemple avec une épaisseur inférieure ou égale à 50 µm) afin que la gravure des étapes des figures 4n et 4o soient rapides et que sensiblement toute l'épaisseur de la première couche de support 20 soit éliminée dans les régions 24.

Puisque, à l'étape 4i, la couche d'oxyde 55 a été formée également sur les surfaces en silicium exposées de la deuxième couche de support 12, la gravure attaque la plaquette uniquement au travers des régions éliminées 45 de la couche d'oxyde enterrée ajourée 40', les autres surfaces de la plaquette étant protégées par la couche d'oxyde 55.

A l'étape illustrée à la figure 4p, la partie restante de la couche de résine 160 est éliminée. Finalement, pour compléter la libération des composants horlogers, on effectue à la figure 4q une étape de désoxydation, ce qui élimine les couches d'oxyde 50 et 55, les parties de la première couche d'oxyde enterrée 40 qui restent entre chaque région 24 et le ou les composants horlogers 90 au-dessus de cette région, et les parties de la deuxième couche enterrée 14 en dessous des régions 24. Cette étape de désoxydation peut être réalisée, par exemple, par une gravure par voie humide ou en phase vapeur à base d'acide fluorhydrique (HF).

Similairement au mode de réalisation de la figure 1 et comme illustré à la figure 3, à la fin de cette étape, on obtient une première couche enterrée structurée 40" dont une partie importante de la couche a été éliminée, mais qui comprend des parties 42, 44 toujours présentes en dehors des zones des composants horlogers 90. Similairement, on obtient une deuxième couche enterrée structurée 14' qui comprend des parties 14A, 14B toujours présentes en dehors des zones des composants horlogers 90. Ces parties subsistantes 42, 44, et 14A, 14B de ces couches d'oxyde enterrées structurées 40", 14' gardent la liaison entre la couche de travail structurée 30' et la deuxième couche de support 12 par le biais des parties restantes 26, 28 de la première couche de support structurée 20'. Par ailleurs, il est encore possible dans ce mode de réalisation qu'une seule région 24 s'étende en dessous de plusieurs voire de tous les composants horlogers de la plaquette.

Après la libération des composants horlogers 90 tel que décrit ci-dessus, une autre étape d'oxydation thermique suivie par une étape de désoxydation peut être réalisée pour effectuer un lissage au moins une nouvelle fois, si souhaité. D'autres étapes de fabrication subséquentes au lissage et à la libération peuvent aussi être effectuées. Par exemple, on peut effectuer une autre étape d'oxydation suivie par une désoxydation pour ajuster les dimensions des composants, ou on peut former une couche d'oxyde de silicium (SiO₂) permanente sur au moins une partie de la surface externe des composants horlogers 90. Dans le cadre d'un spiral ou d'un autre type de résonateur horloger, une telle couche d'oxyde permanente compense les variations du module d'Young de l'âme du spiral en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachées à la plaquette 10, comme par exemple pour assembler le composant à un axe, un tigeron, un piton ou une virole.

Les différentes étapes d'oxydation mentionnées ci-dessus peuvent être réalisées en plaçant la plaquette 10 dans un four à une température comprise entre 800°C et 1200°C et dans une atmosphère oxydante comprenant par exemple la vapeur d'eau ou du gaz de dioxygène (O₂). L'épaisseur de la couche d'oxyde formée dépend de manière connue de la durée de l'étape d'oxydation.

Une fois que les étapes de fabrication des composants horlogers 90 sur la plaquette 10 sont complétées, les composants horlogers peuvent être détachées individuellement (notamment en cassant les ponts 32) et par la suite assemblé et monté chacun dans une pièce d'horlogerie, par exemple dans un oscillateur ou dans un mécanisme d'échappement d'un mouvement horloger mécanique.

La présente invention n'est pas limitée aux modes de réalisation et variantes présentés et d'autres modes de réalisation et variantes apparaîtront clairement à la personne du métier. Ainsi, les réalisations ci-dessus sont des exemples. Bien que la description se réfère à un ou plusieurs modes de réalisation et leurs variantes, ceci ne signifie pas nécessairement que chaque référence concerne le même mode de réalisation ou variante, ou que les caractéristiques s'appliquent seulement à un seul mode de réalisation ou variante. De simples caractéristiques de différents modes de réalisation et leurs variantes peuvent également être combinées et/ou interchangées pour fournir d'autres réalisations.

## Revendications

1. Procédé de fabrication d'une pluralité de composants horlogers (90) en silicium, dans une plaquette multi-couches (10), les composants horlogers présentant des flancs (95) ayant des surfaces, le procédé comprenant les étapes suivantes :
• se doter de la plaquette multi-couches (10) comprenant une première couche de support (20) en silicium, une deuxième couche de support (12, 15), une couche de travail (30) en silicium, et une première couche enterrée (40) en oxyde de silicium séparant la première couche de support (20) de la couche de travail (30), la première couche de support (20) étant supportée par la deuxième couche de support (12, 15) ;
• former les composants horlogers (90) en gravant des motifs dans la couche de travail (30) afin d'obtenir une couche de travail structurée (30'), la couche de travail structurée (30') comprenant des régions (35) autour des motifs gravés dans lesquelles le matériau de la couche de travail a été éliminé pour exposer la première couche d'oxyde enterrée (40) en-dessous ;
• structurer des parties exposées de la première couche d'oxyde enterrée (40) afin d'obtenir une première couche d'oxyde enterrée ajourée (40') comprenant des régions éliminées (45) de la première couche d'oxyde enterrée (40) ;
• structurer la première couche de support (20) afin d'obtenir une première couche de support structurée (20') ayant au moins une région (22, 24) où le matériau de la première couche de support (20) en dessous d'au moins un composant horloger (90) a été éliminé ; et
• éliminer les parties de la première couche d'oxyde enterrée (40) restant entre ladite au moins une région éliminée (22, 24) de la première couche de support structurée (20') et ledit au moins un composant horloger (90) agencé au-dessus de ladite région (22, 24), afin d'obtenir une première couche d'oxyde enterrée structurée (40") ayant des parties subsistantes (42, 44) liant toujours la couche de support structurée (20') à la couche de travail structurée (30'), la première couche de support structurée (20') étant toujours supportée par la deuxième couche de support (12, 15).

2. Procédé selon la revendication précédente, dans lequel la deuxième couche de support (12, 15) comprend au moins une couche, par exemple en silicium, qui n'est pas structurée et reste intacte.

3. Procédé selon l'une des revendications précédentes, dans lequel la deuxième couche de support (12) comprend au moins une couche, par exemple en silicium, qui est réutilisable dans une plaquette multi-couches du même type pour un autre lot de fabrication de composants horlogers.

4. Procédé selon l'une des revendications précédentes, dans lequel la deuxième couche de support (12, 15) est réalisée en au moins un des matériaux suivants : le silicium, l'oxyde de silicium, le carbure de silicium, l'oxyde de hafnium, l'alumine, le nitrure de silicium, le verre, et/ou un métal.

5. Procédé selon l'une des revendications précédentes, dans lequel la plaquette multi-couches (10) comprend également une deuxième couche enterrée (14) séparant la première couche de support (20) de la deuxième couche de support (12).

6. Procédé selon la revendication précédente, dans lequel la deuxième couche de support (12) est réalisée en silicium et la deuxième couche enterrée (14) est réalisée en oxyde de silicium.

7. Procédé selon l'une des revendications précédentes, dans lequel la première couche de support (20) a une épaisseur moins importante que l'épaisseur de la deuxième couche de support (12).

8. Procédé selon l'une des revendications précédentes, dans lequel la première couche de support (20) a une épaisseur inférieure ou égale à 50 µm, de préférence inférieure ou égale à 25 µm, et encore plus préférée inférieure ou égale à 10 µm.

9. Procédé selon l'une des revendications précédentes, dans lequel la première couche de support (20) a une épaisseur d'au moins 3 µm et de préférence d'au moins 5 µm.

10. Procédé selon l'une des revendications précédentes, dans lequel la structuration de la première couche de support (20) a lieu avant un assemblage de la plaquette multi-couches (10), afin que la couche de support structurée (20') se trouve déjà dans la plaquette multi-couches (10) avant la formation des composants horlogers (90) à l'étape (b).

11. Procédé selon l'une des revendications 1 à 9, dans lequel lors de la structuration de la première couche de support (20), on effectue une gravure du silicium dans la première couche de support (20) à travers la première couche d'oxyde enterrée ajourée (40') afin d'obtenir la première couche de support structurée (20').

12. Procédé selon la revendication précédente, comprenant également une étape de former, avant la structuration de la première couche de support (20), une couche de protection (55, 160) au moins sur les surfaces des flancs (95) des composants horlogers gravés dans la couche de travail (30).

13. Procédé selon l'une des revendications 11 ou 12, dans lequel soit la deuxième couche enterrée (14) soit la deuxième couche de support (12, 15) sert à arrêter la gravure de la première couche de support (20) lors de la structuration de la première couche de support (20).

14. Procédé selon l'une des revendications 11 à 13, dans lequel la gravure de la première couche de support (20) comprend une gravure isotrope utilisant un plasma à base d'hexafluorure de soufre (SF₆).

15. Procédé selon l'une des revendications 11 à 13, dans lequel la gravure de la première couche de support (20) comprend une gravure isotrope en phase vapeur à base de difluorure de xénon (XeF₂).

16. Procédé selon l'une des revendications précédentes, dans lequel lors de la gravure des composants horlogers dans la couche de travail (30), un trou traversant (92) est formé dans une zone large de chaque composant horloger (90) afin de réduire le temps de la structuration de la première couche de support (20).

17. Procédé selon l'une des revendications précédentes, dans lequel chaque composant horloger (90) de la plaquette multi-couches (10) a sa propre région éliminée (24) qui s'étend uniquement en dessous de ce composant horloger (90).
